# EUROPÄISCHE PATENTSCHRIFT

(11) **EP 2 687 290 B1**
(45) Veröffentlichungstag und Bekanntmachung des Hinweises auf die Patenterteilung: **24.10.2018**
(21) Anmeldenummer: 13170571.7
(22) Anmeldetag: 05.06.2013
(51) Int. Cl.: B29C 65/16, B01L 3/00, F16K 99/00, B29C 65/00, B29L 31/00

(54) **Mikrofluidische Lagerungsvorrichtung zum Vorlagern eines Fluids, Verfahren zu dessen Herstellung und eine Verwendung derselben**
Microfluidic storage device for storing a fluid, method for its manufacture and use of the same
Dispositif de stockage microfluidique pour le stockage préalable d'un fluide, son procédé de fabrication et une utilisation de celui-ci

(30) Priorität: 19.07.2012 DE 102012212650
(43) Veröffentlichungstag der Anmeldung: 22.01.2014
(73) Patentinhaber: ROBERT BOSCH GMBH, 70442 Stuttgart (DE)
(72) Erfinder: Brettschneider, Thomas, 70806 Kornwestheim (DE); Rothacher, Peter, 76646 Bruchsal (DE)

(56) Entgegenhaltungen:
- DE-A1-102010 028 524
- J.RUPP: "Multilayer Pressure Driven Microfluidic Platform - µFLATLab", TECHNISCHE FAKULTÄT DER ALBERT-LUDWIGS-UNIVERSITÄT ZU FREIBURG IM BREISGAU, 24. Mai 2011 (2011-05-24), XP002715217,
- Manuela Schmidt: "PhD thesis - Untersuchung zum Aufbau hybrider Mikrosysteme unter Verwendung von Polymermaterialien", , 8. März 2012 (2012-03-08), XP055084729, Institut für Mikrosystemtechnik, Universität Freiburg, Germany Gefunden im Internet: URL:http://www.freidok.uni-freiburg.de/vol ltexte/8471/pdf/120112_Dissertation_Schmid t_Veroeffentlichung.pdf [gefunden am 2013-10-21]

## Beschreibung

Die Erfindung bezieht sich auf eine mikrofluidische Lagerungsvorrichtung zum Vorlagern eines Fluids, ein Verfahren zu dessen Herstellung und eine Verwendung derselben.

### Stand der Technik

Lab-on-a-Chip (LOC)-Systeme werden eingesetzt, um Laborvorgänge, die früher von Hand durchgeführt wurden, in einem integrierten System automatisiert ablaufen zu lassen. Dazu umfasst ein LOC-System Kanäle und Kavitäten, die beispielsweise als Mischkavitäten ausgebildet sind oder Möglichkeit bieten, biochemische Reaktionen im vorgegebenen miniaturisierten Volumenbereich ablaufen zu lassen. Die hierfür notwendigen Fluide bzw. Flüssigkeiten werden entweder von außen über fluidische Schnittstellen zugeführt oder im dem LOC-System vorgelagert. Das Vorlagern ermöglicht unter anderem, dass das mikrofluidische Gesamtsystem geschlossen bleibt und ein Kontaminationsrisiko verringert wird.

LOC-Systeme bestehen häufig aus einem polymeren Schichtsystem, das während des Aufbau- bzw. Herstellungsprozesses gefügt wird. Als Fügetechnik wird beispielsweise das Laserschweißen eingesetzt. Beim Laserschweißen trifft ein Laserstrahl durch einen transparenten Fügepartner auf einen Licht absorbierenden Fügepartner, wobei sich die Materialien an der Grenzfläche der Fügepartner verflüssigen und es zu einer Durchmischung der Materialien und einer stoffschlüssigen Verbindung kommt. Auf den Schichtaufbau kann während des Fügeprozesses eine Kraft bzw. ein Kompressionsdruck ausgeübt werden, um einen guten Kontakt zwischen den Fügepartnern sicherzustellen. Dazu wird der zu fügende Schichtaufbau üblicherweise zwischen einer Grundplatte und einer transparenten Druckplatte, beispielsweise einer Glasplatte, eingeklemmt, so dass die Laserstrahlung durch die Druckplatte, z.B. die Glasplatte, auf einen Oberflächenbereich des Licht absorbierenden Fügepartners gelangen kann.

Zu den bisher verwendeten Möglichkeiten zum Vorlagern von Fluiden bzw. Flüssigkeiten in polymeren Schichtsystemen wie etwa LOC-Systemen zählen im System integrierte Blisterverpackungen zum Vorlagern der Fluide bzw. Reagenzien. Ein erstes diesbezügliches Beispiel ist ein LOC-System, das in dem Artikel "Automated Closed-Vessel System for in Vitro Diagnostics Based on Polymerase Chain Reaction" von J.B.Findlay et al., Clinical Chemistry, Vol. 39 (9), Seite 1927 - 1933 (1993) beschrieben ist. Dieses LOC-System umfasst eine Vielzahl von Vorratsgefäßen aus blasgeformten Blisterbehältern. Diese Behälter sind jedoch unverschlossen, was die praktischen Einsatzmölichkeiten sehr einschränkt. Ein zweites diesbezügliches Beispiel ist in dem Artikel "Clinical applications of a programmable nano-bio-chip" von J.V.Jokerst et al., Clinical Laboratory International, Vol. 33 (6), Seite 24 - 27 (November 2009) bezüglich eines beispielhaften kommerziell erhältlichen Nano-Bio-Chip der Firma LabNow erwähnt. Dabei werden zum Freigeben der Reagenzien aus den Blisterverpackungen Berstventile in dem System (mikrofluidischer Chip) integriert, die sich jedoch fertigungstechnisch schwer mit hoher Prozesssicherheit realisieren lassen.

Zu den bekannten Möglichkeiten zum Vorlagern von Fluiden bzw. Flüssigkeiten in polymeren Schichtsystemen zählt ferner das Dispensieren von Fluiden in zuvor ausgebildeten Kavitäten in einer Polymerschicht und das anschließende Fügen des Schichtaufbaus, beispielsweise mittels Laserdurchstrahlschweißen, wie etwa in der Dissertation (Ph.D. thesis) "Multilayer Pressure Driven Microfluidic Platform - µFLATLab" von J.Rupp, die der Technischen Fakultät der Albert-Ludwigs-Universität zu Freiburg im Breisgau am 24.05.2011 vorgelegt wurde, beschrieben ist (siehe http://www.freidok.uni-freiburg.de/volltexte/8374/pdf/111129 Rp Dissertation actual.pdf).

DE 10 2010 028 524 A1 offenbart ein mikrofluidisches Bauteil, mindestens umfassend einen Schichtaufbau aus einem fluidischen Substrat, einem Ansteuerungssubstrat und einer dazwischen angeordneten elastischen Membran, wobei das fluidische Substrat auf seiner an die elastische Membran angrenzenden Seite eine Fluidkammer aufweist, das Ansteuerungssubstrat, mindestens auf seiner an die elastische Membran angrenzenden Seite, mindestens zwei voneinander getrennte Aktuierungskomponenten aufweist, die jeweils mindestens teilweise der Fluidkammer gegenüber angeordnet sind und auf die elastische Membran einwirken können und die Aktuierungskomponenten, gegebenenfalls durch ein oder mehrere Aktoren, unabhängig voneinander aktuierbar sind.

### Offenbarung der Erfindung

Die Erfindung schafft eine mikrofluidische Lagerungsvorrichtung mit den Merkmalen des beigefügten unabhängigen Anspruchs 1, eine Verwendung derselben nach Anspruch 9 und ein Verfahren zu deren Herstellung mit den Merkmalen des Anspruchs 10. Vorteilhafte Ausführungsformen der Lagerungsvorrichtung bzw. des Verfahrens sind Gegenstände der abhängigen Ansprüche.

Die Erfindung hat den Vorteil, eine mikrofluidische Lagerungsvorrichtung und ein Verfahren zu dessen Herstellung bereitzustellen, wobei ein Fluid, insbesondere eine Flüssigkeit besonders vorteilhaft in einem Polymerschichtsystem vorgelagert werden und während eines ohnehin notwendigen Klemmvorgangs für den Verfügeprozess, z.B. mittels Laserschweißen, unter verschlossenen Bedingungen, d.h. ohne Verbindung mit der Atmosphäre bzw. der Umgebung, eingefüllt werden kann.

### Weitere Vorteile der Erfindung

Wenn die elastische Polymermembran durch das eingefüllte Fluid in die Ausnehmung hinein gedrückt wird, entsteht eine mechanische Spannung in der Polymermembran, die das Fluid unter einen Druck (Vordruck) setzt.

Die in der erfindungsgemäßen Lagerungsvorrichtung vorgesehene Lagerung des Fluids in dem Volumenbereich innerhalb der Ausnehmung zwischen der Polymermembran und dem zweiten Polymersubstrat ermöglicht es, die vorzulagernde Menge des Fluids durch das Volumen (laterale Erstreckung und Tiefe) der Ausnehmung in weiten Grenzen zu gestalten. Ferner steht das vorgelagerte Fluid aufgrund der in die Ausnehmung hinein vorgespannten Polymermembran unter einem Vordruck, der beim Gebrauch des Fluids das Entleeren antreiben kann.

Das erste Polymersubstrat umfasst folgendes: ein erstes Durchloch, ein erstes Hilfsdurchloch, das zwischen dem ersten Durchloch und der Ausnehmung ausgebildet ist, ein zweites Durchloch, das bezüglich der Ausnehmung dem ersten Durchloch im Wesentlichen gegenüberliegend angeordnet ist, und ein zweites Hilfsdurchloch, das zwischen dem zweiten Durchloch und der Ausnehmung ausgebildet ist. Vorzugsweise können in dieser Ausführungsform überdies das erste Durchloch, das erste Hilfsdurchloch, das zweite Durchloch und das zweite Hilfsdurchloch jeweils in die erste Oberfläche münden. Diese Ausgestaltung des ersten Polymersubstrats ermöglicht, dass beim Herstellen der mikrofluidischen Lagerungsvorrichtung das Fluid durch das erste Durchloch in den zum Vorhalten vorgesehenen Bereich in der Ausnehmung eingefüllt werden kann, und dass das eingefüllte Fluid durch Beaufschlagen von Überdrucken an dem ersten und zweiten Hilfsdurchloch eingeschlossen werden kann.

In dem ersten Polymersubstrat kann ferner ein Entlüftungskanal ausgebildet sein, wobei dieser eine Fluidkommunikation zwischen der Ausnehmung und einem Raum außerhalb der Lagerungsvorrichtung bereitstellen kann. Die durch Entlüftungskanal bereitgestellte Fluidkommunikation aus der Ausnehmung nach außerhalb der Lagerungsvorrichtung ermöglicht, dass das beim Herstellen der Lagerungsvorrichtung durch ein Durchloch eingefüllte Fluid in der Ausnehmung vorhandene Luft im Wesentlichen vollständig verdrängen kann, so dass die Ausnehmung im Wesentlichen vollständig mit dem Fluid ausgefüllt werden kann.

In dem zweiten Polymersubstrat sind in dessen zweiter Oberfläche ein erster Kanal und ein zweiter Kanal so ausgebildet, und die zweite Oberfläche des zweiten Polymersubstrats mit dem dazwischen angeordneten Polymermembran ist derart an die erste Oberfläche des ersten Polymersubstrats angelegt, dass der erste Kanal den Bereich, der in der zweiten Oberfläche in Verlängerung des ersten Durchlochs angeordnet ist, mit dem Bereich, der in der zweiten Oberfläche in Verlängerung des ersten Hilfsdurchlochs angeordnet ist, und einem nahe gelegenen ersten Bereich, der in der zweiten Oberfläche gegenüber einem Teilbereich der Ausnehmung angeordnet ist, miteinander verbinden kann, und dass der zweite Kanal den Bereich, der in der zweiten Oberfläche in Verlängerung des zweiten Durchlochs angeordnet ist, mit dem Bereich, der in der zweiten Oberfläche in Verlängerung des zweiten Hilfsdurchlochs angeordnet ist, und einem nahe gelegenen zweiten Bereich, der in der zweiten Oberfläche gegenüber einem Teilbereich der Ausnehmung angeordnet ist, miteinander verbinden kann. In weiterer Ausgestaltung des zweiten Polymersubstrats können der erste Kanal und der zweite Kanal in dem Bereich, der sich auf der zweiten Oberfläche gegenüber der Ausnehmung befindet, miteinander verbunden sein. Diese Verbindung kann beispielsweise durch einen Verbindungskanal vermittelt werden. Diese Ausgestaltung des zweiten Polymersubstrats ermöglicht, dass beim Herstellen der mikrofluidischen Lagerungsvorrichtung das Fluid durch das erste bzw. zweite Durchloch eingefüllte Fluid durch ersten bzw. zweiten Kanal in den zum Vorhalten vorgesehenen Bereich in der Ausnehmung strömen und diesen befüllen kann.

Die Polymermembran kann zumindest in Bereichen außerhalb der Ausnehmung in dem Bereich, der in der zweiten Oberfläche in Verlängerung des ersten Hilfsdurchlochs angeordnet ist, mit der Wand des ersten Kanals und in dem Bereich, der in der zweiten Oberfläche in Verlängerung des zweiten Hilfsdurchlochs angeordnet ist, und mit der Wand des zweiten Kanals gefügt sein. Dadurch wird der zum Vorhalten des Fluids vorgesehene Volumenbereich in der Ausnehmung peripher im Wesentlichen vollständig durch die Fügung der Polymermembran mit dem ersten und zweiten Polymersubstrat abgedichtet.

Das Fluid kann zumindest in dem Volumenbereich in der Ausnehmung zwischen der Polymermembran und der zweiten Oberfläche eingefüllt sein. Dabei ist die elastische Polymermembran durch das eingefüllte Fluid in die Ausnehmung hinein, und die dadurch entstandene mechanische Spannung in der Polymermembran setzt das Fluid unter einen Druck (Vordruck). In weiterer Ausgestaltung können das erste Polymersubstrat, die Polymermembran und das zweite Polymersubstrat zumindest in Teilbereichen außerhalb der Ausnehmung, in welchen Bereichen die Polymermembran mit der ersten und der zweiten Oberfläche in Kontakt ist, miteinander verfügt sein. Dadurch nimmt das Fluid den zum Vorhalten vorgesehenen Volumenbereich ein und dieser Volumenbereich ist peripher nach außen im Wesentlichen vollständig abgedichtet bzw. eingeschlossen.

Wenigstens das erste Durchloch, das erste Hilfsdurchloch, das zweite Durchloch oder das zweite Hilfsdurchloch kann mit einem Polymerstempel verschlossen sein. Vorzugsweise sind alle diese Löcher (d.h. das erste und zweite Durchloch sowie das erste und zweite Hilfsdurchloch) mit einem Polymerstempel verschlossen. Der bzw. die Polymerstempel bewirken eine zusätzliche Abdichtung bzw. Einschluss des Fluids in dem zum Vorhalten vorgesehenen Volumenbereich in der Ausnehmung.

Die Lagerungsvorrichtung kann ferner mindestens ein Durchbruchventil mit einem Ventilvorraum umfassen. Dabei kann das Durchbruchventil in dem ersten Polymersubstrat ausgebildet und der Ventilvorraum in Fluidkommunikation mit der Ausnehmung sein. In weiterer vorzugsweiser Ausgestaltung kann dabei das Durchbruchventil zumindest teilbereichsweise gegenüber dem ersten oder zweiten Kanal zwischen der Ausnehmung und dem ersten bzw. zweiten Hilfsdurchloch ausgebildet sein. Das Durchbruchventil ermöglicht ein Öffnen des das Fluid vorhaltenden Volumenbereichs nach außerhalb bzw. ein Ausfließen des vorgehaltenen Fluids, wenn das Durchbruchventil geöffnet worden ist.

Die Polymermembran kann absorbierend sein für Licht, für das das erste und das zweite Polymersubstrat durchlässig ist und das zum Verfügen des ersten Polymersubstrats mit der Polymermembran und des zweiten Polymersubstrats mit der Polymermembran geeignet ist, insbesondere beispielsweise mittels Laserschweißen. Diese Ausgestaltung ermöglicht beim Herstellen der mikrofluidischen Lagerungsvorrichtung ein effektives Verfügen der Polymermembran mit dem ersten und zweiten Polymersubstrat mittels Laserschweißen.

Die Wände des ersten bzw. des zweiten Kanals können in den Bereichen, in denen die Polymermembran gebogen ist, abgeschrägt ausgebildet sein. Diese Ausgestaltung ermöglicht, dass die Polymermembran die Wände des ersten bzw. zweiten Kanals im Wesentlichen vollständig bis zum Rand des ersten bzw. zweiten Kanals kontaktieren kann.

Das erste und/oder das zweite Polymersubstrat kann aus einem thermoplastischen Material hergestellt sein. Insbesondere kann das thermoplastische Material aus einer Gruppe ausgewählt sein, die PC, PP, PE, PMMA, COP und COC umfasst. Die Polymermembran kann aus einem Material hergestellt sein, das aus einer Gruppe ausgewählt ist, die Elastomere, thermoplastische Elastomere, Thermoplaste und Heißklebefolien umfasst. Diese Materialien sind kommerziell verfügbar und ermöglichen eine bezüglich der Rohstoffkosten kostengünstige Fertigung.

Erfindungsgemäß wird die oben beschriebene mikrofluidische Lagerungsvorrichtung in einem Lab-on-a-Chip (LOC) verwendet bzw. kann darin verwendet werden.

Ein erfindungsgemäßes Verfahren zur Herstellung einer mikrofluidischen Lagerungsvorrichtung zum Vorlagern eines Fluids umfasst die folgenden Schritte:
(a) Herstellen eines ersten Polymersubstrats mit einer ersten Oberfläche, in der eine sich lateral erstreckende Ausnehmung ausgebildet ist, wobei das erste Polymersubstrat ferner ein erstes Durchloch, ein erstes Hilfsdurchloch, das zwischen dem ersten Durchloch und der Ausnehmung ausgebildet ist, ein zweites Durchloch, das bezüglich der Ausnehmung dem ersten Durchloch im Wesentlichen gegenüberliegend angeordnet ist und ein zweites Hilfsdurchloch, das zwischen dem zweiten Durchloch und der Ausnehmung ausgebildet ist.
(b) Herstellen eines zweiten Polymersubstrats mit einer zweiten Oberfläche, die in Bereichen außerhalb der Ausnehmung im Wesentlichen formschlüssig passend zu der ersten Oberfläche ausgebildet ist und in der ein erster Kanal und ein zweiter Kanal ausgebildet ist, wobei, wenn die erste Oberfläche des ersten Polymersubstrats an die zweite Oberfläche des zweiten Polymersubstrats gelegt ist, der erste Kanal den Bereich, der in der zweiten Oberfläche in Verlängerung des ersten Durchlochs angeordnet ist, mit dem Bereich, der in der zweiten Oberfläche in Verlängerung des ersten Hilfsdurchlochs angeordnet ist, und einem nahe gelegenen ersten Bereich, der in der zweiten Oberfläche gegenüber der Ausnehmung angeordnet ist, miteinander verbindet, und der zweite Kanal den Bereich, der in der zweiten Oberfläche in Verlängerung des zweiten Durchlochs angeordnet ist, mit dem Bereich, der in der zweiten Oberfläche in Verlängerung des zweiten Hilfsdurchlochs angeordnet ist, und einem nahe gelegenen zweiten Bereich, der in der zweiten Oberfläche gegenüber der Ausnehmung angeordnet ist, miteinander verbindet;
(c) Ausbilden einer Stapelanordnung umfassend das erste Polymersubstrat, das zweite Polymersubstrat und eine Polymermembran, die zwischen dem ersten Polymersubstrat und dem zweiten Polymersubstrat angeordnet wird;
(d) Einfüllen des Fluids in das erste Durchloch bis das Fluid durch das zweite Durchloch austritt;
(e) Beaufschlagen eines Überdrucks an das zweite Hilfsdurchloch, so dass sich die Polymermembran im Bereich des zweiten Hilfsdurchlochs von dem ersten Polymersubstrat abhebt und im Wesentlichen in diesem Bereich an der Wand des zweiten Kanals angedrückt wird;
(f) weiterhin Einfüllen des Fluids in das erste Durchloch bis sich die Polymermembran in die Ausnehmung hinein gedrückt hat und die Ausnehmung im Wesentlichen auskleidet, und der Volumenbereich zwischen der Polymermembran und dem zweiten Polymersubstrat im Bereich der Ausnehmung im Wesentlichen vollständig mit Fluid gefüllt ist;
(g) Beaufschlagen eines Überdrucks an das erste Hilfsdurchloch, so dass sich die Polymermembran im Bereich des ersten Hilfsdurchlochs von dem ersten Polymersubstrat abhebt und im Wesentlichen in diesem Bereich an der Wand des ersten Kanals angedrückt wird;
(h) Fügen der Polymermembran in den Bereichen des ersten und des zweiten Hilfsdurchlochs, die in Kontakt mit der Wand des ersten bzw. des zweiten Kanals sind; und
(i) Fügen der übrigen Flächenbereiche der Oberflächen des ersten und zweiten Polymersubstrats mit der Polymermembran zumindest in Teilbereichen außerhalb der Ausnehmung.

Durch dieses Verfahren kann die oben beschriebene Lagerungsvorrichtung aus relativ einfach aufgebauten bzw. bereitzustellenden Komponenten (einschließlich das erste Polymersubstrat, die Polymermembran und das zweite Polymersubstrat) hergestellt werden, und das erste Polymersubstrat weist eine geringstmögliche Anzahl von Durchlöchern auf.

Im Schritt (f) wird die elastische Polymermembran durch das eingefüllte Fluid in die Ausnehmung hinein gedrückt, und die dadurch entstandene mechanische Spannung in der Polymermembran setzt das Fluid unter einen Druck (Vordruck).

Nach dem Schritt (h) kann die Polymermembran in einem ersten Bereich bzw. einer ersten Durchtrennstelle, die sich zwischen der im Schritt (e) ergebenden ersten Andruckstelle des Polymersubstrats an Wand des zweiten Kanals und einer ersten Öffnung in der Polymermembran an einer Stelle in Verlängerung des ersten Durchlochs befindet, und in einem zweiten Bereich an einer zweiten Durchtrennstelle, die sich zwischen der im Schritt (g) ergebenden zweiten Andruckstelle des Polymersubstrats an die Wand des ersten Kanals und einer zweiten Öffnung in der Polymermembran an einer Stelle in Verlängerung des zweiten Durchlochs befindet, mit einem Laserstrahl mit höherer Leistung des Lasers durchtrennt werden.

Nach dem Durchtrennen in den vorstehend beschrieben ersten und zweiten Bereichen bzw. ersten und zweiten Durchtrennstellen kann der in dem in Ausnehmung eingefüllten Fluid herrschende Überdruck (Vordruck) an dem ersten Hilfsdurchloch bzw. dem zweiten Hilfsdurchloch das außerhalb der Andruckstellen in dem ersten bzw. zweiten Kanal befindliche Fluid durch das erste Durchloch bzw. durch das zweite Durchloch im ersten Polymersubstrat verdrängen und dadurch das überschüssige Fluid kontrolliert abführen.

Ausgehend von einem Polymerschichtsystem mit zwei transparenten Polymersubstraten mit Kanälen und Kammern, die durch eine absorbierende flexible Polymermembran getrennt und mit den eingebrachten Kanälen bzw. Kammern einander zugewendet aufeinandergelegt sind, besteht ein Aspekt des erfindungsgemäßen Verfahren aus der fluidischen Kontaktierung des Polymerschichtsystems (umfassend das erste Polymersubstrat, die Polymermembran und das zweite Polymersubstrat) und der Verwendung von Differenzdrucken innerhalb des Schichtaufbaus während der Klemmung beim Fügeprozess (Schritt (h)), beispielsweise einem Laserschweißprozess. Hierdurch ist es möglich, die flexible Polymermembran während des Klemm- bzw. Pressvorgangs in einer äußeren Klemmhalterung, die beispielsweise aus ersten Druckplatte (Grundplatte) und einer zweiten Druckplatte besteht, kontrolliert in einem definierten Bereich des Polymerschichtsystems auszulenken und dabei gegen eines der Polymersubstrate zu pressen. In diesem Zustand kann die Polymermembran mit den Polymersubstraten verfügt, beispielsweise mit dem Laser verschweißt, werden.

Im Schritt (a) können das erste Durchloch, das erste Hilfsdurchloch, das zweite Durchloch und das zweite Hilfsdurchloch jeweils in die erste Oberfläche münden. Während des Schritts (c) können das erste bzw. zweite Polymersubstrat in Richtung aufeinander zu aneinandergepresst werden. Das Aneinanderpressen unterstützt die Ausbildung einer materialschlüssigen Verbindung des ersten bzw. zweiten Polymersubstrats mit der dazwischen gelegten Polymermembran beim Verfügen Im Schritt (a) können die Strukturen in der ersten Oberfläche des ersten Polymersubstrats und/oder im Schritt (b) die Strukturen in der zweiten Oberfläche des zweiten Polymersubstrats durch Fräsen, Spritzguss, Heißprägen oder Laserstrukturierung hergestellt werden. Die Durchbrüche in der Polymermembran in den Bereichen des ersten Durchlochs und/oder des zweiten Durchlochs können durch Stanzen oder Laserstrukturierung hergestellt werden. Diese Bearbeitungstechniken sind geläufig und ermöglichen das Bereitstellen der Komponenten (d.h. das erste und zweite Polymersubstrat und die Polymermembran) und das Ausbilden der Strukturen in der erforderlichen geometrischen Genauigkeit und mit bekannten Bearbeitungsmaschinen.

Der gefügte Polymerstapel (d.h. die fertiggestellte Lagerungsvorrichtung) und das Verfahren können zur Vorlagerung eines Fluids, etwa einer Probe oder eines Reagenzfluids, verwendet werden. Hierzu wird der vorgehend beschriebene Schichtaufbau zusammengepresst und dabei fluidisch kontaktiert. Während des Pressvorgangs wird über einen ersten Zugang, der durch das erste bzw. zweite Durchloch im ersten Polymersubstrat implementiert ist, ein Fluid (z.B. eine Flüssigkeit) in das Polymerschichtsystem eingebracht. Über einen zweiten und dritten fluidischen Zugang, die Druckzugänge sind und durch das erste und zweite Hilfsdurchloch im ersten Polymersubstrat implementiert sind, wird danach die Polymermembran in vorher definierten Bereichen, insbesondere im Bereich der Ausnehmung (Kavität) so ausgelenkt, dass sie das eingebrachte Fluid einschließt. In diesem Zustand wird die in die Ausnehmung bzw. Kavität ausgelenkte Polymermembran in den die Ausnehmung bzw. Kavität umringenden Bereichen mit dem gegenüberliegenden Polymersubstrat gefügt.

Das eingeschlossene Fluid kann über Berstventile, die im gleichen Polymerschichtaufbau vorgesehen sind, entleert werden. In einem Berstventil sind Sollbruchstellen integriert, die sich mittels kleiner Stempel aufbrechen lassen. Da eine z.B. aus einem Elastomer hergestellte Polymermembran in der Regel sehr permeabel ist, ist sie alleine für eine langfristige Lagerung von Fluiden, insbesondere flüssiger Reagenzien, nicht geeignet. Werden jedoch die Zugänge zum Befüllen (insbesondere das erste und zweite Durchloch) und zum Anlegen von Drucken (insbesondere das erste und zweite Hilfsdurchloch) zusätzlich zum Verfügen der Polymermembran mit einem beispielsweise heißen Stempel verschlossen und verschmolzen, entsteht in Verbindung mit dem Berstventil eine allseitig mit Polymer umhüllte Fluidkaverne (einschließlich insbesondere der Ausnehmung), die weitgehend permeationsdicht und für eine langfristige Vorlagerung (beispielsweise für eine Dauer von mehr als einem Jahr) flüssiger Reagenzien geeignet ist.

Die hier beschriebenen Berstventile lassen sich aus einem einzigen kostengünstigen Spritzgussteil aufbauen und einfach montieren. Dies im Gegensatz beispielsweise zu den Berstventilen, die in dem Artikel von Xie et al: "Development of a disposable bio-microfluidic package with reagents self-contained reservoirs", IEEE Transactions on Advanced Packaging, Vol. 32 (2), Seiten 528 bis 543 (Mai 2009) beschrieben sind. Die dort beschriebenen Berstventile sind durch in der Herstellung relativ teure rohrartige Mikronadeln realisiert, die überdies aus PDMS (Polydimethylsiloxan, ein Polymer auf Siliziumbasis), was keine Permeationsdichtigkeit gewährleistet und für eine langfristige Lagerung ungeeignet ist, hergestellt sind.

Durch die Erfindung ergeben sich folgende weitere Vorteile:
1. Im Vergleich zu bisherigen Vorhaltevorrichtungen, die z.B. in der Form von in der Vorrichtung integrierten Blisterverpackungen realisiert waren, entfallen die vorher (d.h. vor der Integration der Blisterverpackung in der Vorrichtung) notwendigen Prozessschritte zum Einfüllen und Einschließen des Fluids in der Verpackung.
2. Der Prozessschritt des Dispensierens des Fluids vor dem Fügeprozess (z.B. durch Laserschweißen) entfällt. Hierdurch ergeben sich niedrigere Herstellungskosten und schnellere Prozesszeiten.
3. Wenn die Fluide (Proben und Reagenzien) an Luft in vorher definierte Kavitäten bzw. Blisterverpackungen eingefüllt werden, dann sind Reinraumbedingungen während des Herstellungsprozesses unabdingbar, um eine Kontamination zu vermeiden. Bei dem erfindungsgemäßen Verfahren hat jedoch das einzufüllende Fluid zu keinem Zeitpunkt Kontakt zur Außenwelt. Daher während der Herstellung der Lagerungsvorrichtung kann auf Reinraumbedingungen verzichtet werden.
4. Oft ist es problematisch, ein in einem Mikrofluidsystem vorgelagertes Fluid wieder gezielt entleeren zu können. Wenn man jedoch die Flexibilität der Polymermembran ausnutzt, dann lassen sich Fluide unter dauerhaftem Druck vorlagern. Beim Öffnen der fluidgefüllten Ausnehmung (Kavität), beispielsweise über die genannten Berstventile, kann die Ausnehmung (Kavität) sich selbständig ohne Anlegen eines zusätzlichen Drucks entleeren.
5. In der Regel ist es sehr schwierig, Flüssigkeiten ohne Luftblaseneinschlüsse vorzulagern bzw. diese auch blasenfrei in eine mikrofluidische Vorrichtung zu entleeren. Mit der Anordnung des Entlüftungskanals und von Befüll- und Berstventilen lassen sich Luftblasen bei der Befüllung und Entleerung vermeiden.
6. Mit der erfindungsgemäßen Anordnung von Befüll- und Berstventilen lassen sich Fluide (Proben bzw. Reagenzien) in Polymerstrukturen mit niedrigem Permeationsgrad vorlagern, sodass eine langfristige Lagerung möglich ist.
7. Viele bisher bekannte LOC-Systeme sind druckgetrieben, d.h., das LOC enthält fluidische Anschlüsse, die während des Betriebs mit unterschiedlichen Drucken beaufschlagt werden, um entsprechende fluidische Abläufe in dem LOC zu realisieren. Die erfindungsgemäße Lagerungsvorrichtung ermöglicht es, Fluide (Flüssigkeiten und Gase) unter Druck (der durch die vorgespannte elastische Polymermembran erzeugte Vordruck) vorzulagern und diese vorgelagerten Fluide durch eine mechanische Aktuierung (z.B. des Berstventils) freizusetzen. Damit kann auf fluidische Schnittstellen zum Steuern von Betriebsabläufen während des Betriebs verzichtet werden. Dies reduziert die Komplexität der zugehörigen externen Steuerungseinheiten.

### Kurze Beschreibung der Figuren

Die Erfindung wird im Folgenden beispielhaft anhand von in den beigefügten Figuren dargestellten Ausführungsformen der Erfindung in weiteren Einzelheiten beschrieben. In den Figuren zeigen:
Fig. 1A eine schematische Aufsicht auf das erste Polymersubstrat;
Fig. 1B eine schematische Querschnittsansicht durch das erste Polymersubstrat aus der Fig. 1A, wobei dieses zwischen Druckplatten eingespannt ist;
Fig. 2A eine schematische Aufsicht auf einen Polymerstapel umfassend das erste Polymersubstrat und das darunter angeordnete zweite Polymersubstrat gemäß einer ersten Ausführungsform der Erfindung;
Fig. 2B eine schematische Querschnittsansicht durch den Polymerstapel aus der Fig. 2A (umfassend das erste Polymersubstrat, die Polymermembran und das zweite Polymersubstrat), wobei dieser Polymerstapel zwischen Druckplatten eingespannt sind;
Fig. 3 eine schematische Querschnittsansicht des zwischen Druckplatten eingespannten Polymerstapels aus der Fig. 2B nach einem ersten Prozessschritt des Einfüllens von Fluid;
Fig. 4 eine schematische Querschnittsansicht des zwischen Druckplatten eingespannten Polymerstapels aus der Fig. 3 nach einem weiteren Prozessschritt des Beauschlagens eines Überdrucks;
Fig. 5 eine schematische Querschnittsansicht des zwischen Druckplatten eingespannten Polymerstapels aus der Fig. 4 nach einem weiteren Prozessschritt des Verfügens der Polymermembran in Teilbereichen mit dem zweiten Polymersubstrat;
Fig. 6 eine schematische Querschnittsansicht des zwischen Druckplatten eingespannten Polymerstapels aus der Fig. 6 nach einem weiteren Prozessschritt des Durchtrennens der Polymermembran in Bereichen zwischen den Durchlöchern und den Hilfsdurchlchern;
Fig. 7 eine schematische Querschnittsansicht des zwischen Druckplatten eingespannten Polymerstapels aus der Fig. 7 nach einem weiteren Prozessschritt des Ausblasens des Fluids aus den Durchlöchern;
Fig. 8A eine schematische Aufsicht auf einen Polymerstapel umfassend das erste Polymersubstrat mit einem darin ausgebildeten Berstventil und das darunter angeordnete zweite Polymersubstrat gemäß einer zweiten Ausführungsform der Erfindung;
Fig. 8B eine schematische Querschnittsansicht durch den Polymerstapel aus der Fig. 2A, umfassend das erste Polymersubstrat, die Polymermembran und das zweite Polymersubstrat, wobei dieser Polymerstapel zwischen Druckplatten eingespannt ist;
Fig. 9A eine schematische Querschnittsansicht durch einen Polymerstapel umfassend ein erstes Polymersubstrat, einer Polymermembran und einem zweiten Polymersubstrat, wobei in dem ersten Polymersubstrat ein Berstventil in einer ersten Variante ausgebildet ist; und
Fig. 9B eine schematische Querschnittsansicht durch einen Polymerstapel ähnlich wie in Fig. 9A, wobei in dem ersten Polymersubstrat ein Berstventil in einer zweiten Variante ausgebildet ist.

### Ausführungsformen der Erfindung

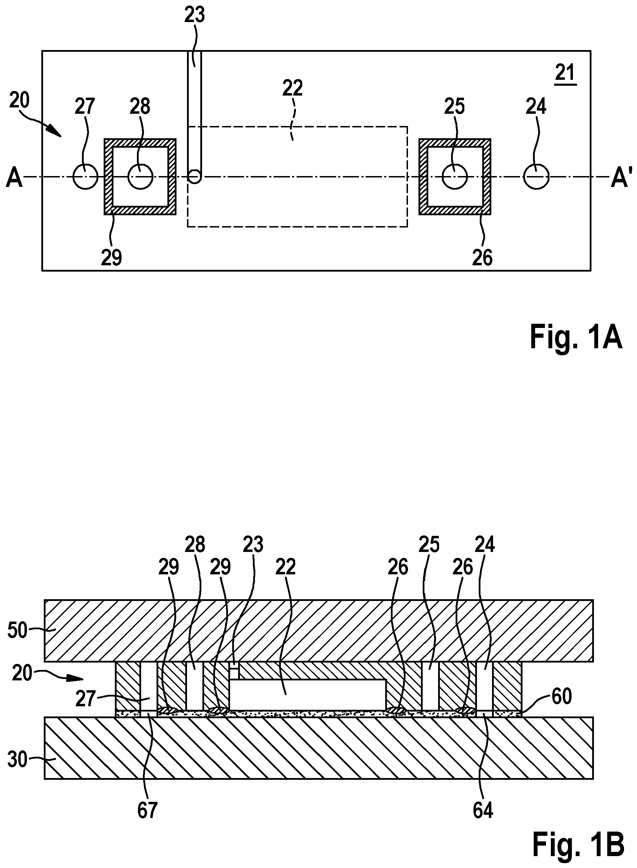

In den Figuren 1 bis 7 wird eine mikrofluidische Lagerungsvorrichtung gemäß einer ersten Ausführungsform der Erfindung und ein Verfahren zu dessen Herstellung gezeigt. Die fertiggestellte mikrofluidische Lagerungsvorrichtung 10 kann zum Vorlagern eines Fluids 70, beispielsweise in einem Lab-on-a-Chip(LOC)-System, verwendet werden. Die Lagerungsvorrichtung 10 umfasst ein erstes Polymersubstrat 20 mit einer ersten Oberfläche 21, in der eine sich lateral erstreckende Ausnehmung 22 ausgebildet ist, ein zweites Polymersubstrat 40 mit einer zweiten Oberfläche 41, die im Wesentlichen formschlüssig passend an die erste Oberfläche 21 ausgebildet ist in den Bereichen außerhalb der Ausnehmung 21, eine elastische Polymermembran 60, die zwischen dem ersten und zweiten Polymersubstrat 20, 40 angeordnet ist, die in Bereichen außerhalb der Ausnehmung 22 mit der ersten und mit der zweiten Oberfläche 21, 41 in Kontakt ist und die im Bereich der Ausnehmung 22 diese im Wesentlichen auskleidet. So ist im Wesentlichen der Volumenbereich innerhalb der Ausnehmung 22 zwischen der Polymermembran 60 und dem zweiten Polymersubstrat 40 mit dem Fluid befüllbar bzw. befüllt. Dabei ist das erste Polymersubstrat 20, die Polymermembran 60 und das zweite Polymersubstrat 40 in Bereichen außerhalb der Ausnehmung 22, in denen die Polymermembran 60 mit der ersten und zweiten Oberfläche 21, 41 in Kontakt ist, miteinander verfügbar bzw. verfügt.

Das in den Figuren 1A und 1B gezeigte erste Polymersubstrat 20 umfasst zusätzlich zu der Ausnehmung 22 ein erstes Durchloch 24, ein erstes Hilfsdurchloch 25, ein zweites Durchloch 27 und ein zweites Hilfsdurchloch 28. Das zweite Durchloch 27 ist bezüglich der Ausnehmung 22 dem ersten Durchloch 24 im Wesentlichen gegenüberliegend angeordnet. Das erste Hilfsdurchloch 25 ist zwischen dem ersten Durchloch 24 und der Ausnehmung 22 ausgebildet. Das zweite Hilfsdurchloch 28 ist zwischen dem zweiten Durchloch 27 und der Ausnehmung 22 ausgebildet. Das erste und zweite Durchloch 24, 27 sowie das erste und zweite Hilfsdurchloch 25, 28 münden jeweils in die erste Oberfläche 21. In dem ersten Polymersubstrat 20 ist in der ersten Oberfläche 21 ferner ein Entlüftungskanal 23 ausgebildet, der eine Fluidkommunikation zwischen der Ausnehmung 22 und einem Raum außerhalb des ersten Polymersubstrats 20 bereitstellt und der im Wesentlichen lateral in einer Ebene parallel zu der Ausnehmung 22 ausgebildet ist.

Eine für das erfindungsgemäße Herstellungsverfahren vorgefertigte Polymermembran weist im Wesentlichen die gleichen lateralen Abmessungen auf wie das erste und zweite Polymersubstrat 20, 40. In der vorgefertigten Polymermembran 60 ist eine erste Öffnung 64 im Wesentlichen deckungsgleich mit dem ersten Durchloch 24 und eine zweite Öffnung 67 im Wesentlichen deckungsgleich mit dem zweiten Durchloch 27 des ersten Polymersubstrats 20 ausgebildet, siehe Fig. 1B.

Das erste und zweite Polymersubstrat 20, 40 ist jeweils aus einem lichtdurchlässigen (d.h. für den Laserstrahl im Wesentlichen transparenten) Material hergestellt. Die Polymermembran 60 ist aus einem lichtabsorbierenden (d.h. das Laserlicht absorbierenden) Material hergestellt.

In einem ersten Schritt des erfindungsgemäßen Herstellungsverfahrens wird das erste Polymersubstrat 20 (wie in Fig. 1A gezeigt) mit den darin ausgebildeten Strukturen 22, 23, 24, 25, 28, 29 der vorgefertigten Polymermembran 60 zugewendet auf das Polymersubstrat deckungsgleich aufgelegt. Der so ausgebildete Zwischenverbund wird auf einer lichtabsorbierenden Grundplatte 30 aufgelegt. Die Grundplatte 30 dient dabei als erste (untere) Druckplatte 30. Eine zweite Druckplatte 50 wird auf den Stapel aufgelegt, wie in Fig. 1B gezeigt. Sodann wird die Polymermembran 60 mit dem ersten Polymersubstrat 20 entlang einer ersten Kontur 26, die sich um das erste Hilfsdurchloch 25 herum erstreckt, und entlang einer zweiten Kontur 29, die sich um das zweite Hilfsdurchloch 28 herum erstreckt, mit dem ersten Polymersubstrat 20 verfügt. Zum Verfügen wird das Laserschweißen verwendet. Dabei wird ein Laserstrahl (in Fig. 1B nicht gezeigt) in Fig. 1B von oben durch die zweite Druckplatte 50 und die Dicke des ersten Polymersubstrats 20 hindurch auf die Polymermembran 60 gerichtet (z.B. fokussiert), und entlang der ersten Kontur 26 und entlang der zweiten Kontur 28 geführt. Dabei schmilzt die Polymermembran entlang der ersten und zweiten Kontur 26, 29 auf und geht eine stoffschlüssige Verbindung entlang der Konturen 26, 29 mit dem ersten Polymersubstrat 20 ein.

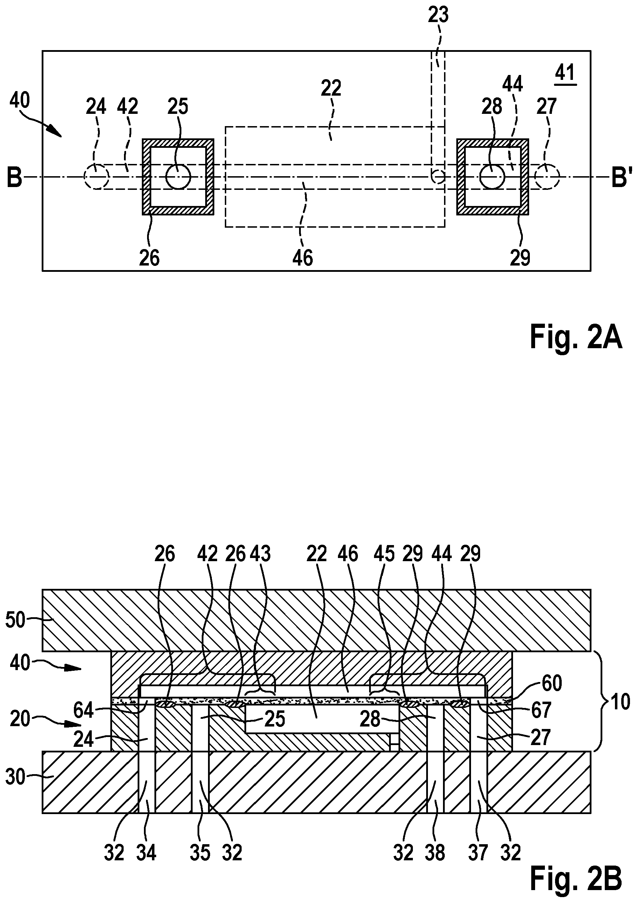

Sodann wird der verfügte Zwischenverbund bestehend aus dem ersten Polymersubstrat 20 und der Polymermembran 60 von der Grundplatte 30 entfernt, umgedreht und wieder auf der Grundplatte 30 aufgelegt, wie in Fig. 2B gezeigt. Ferner wird ein zweites vorgefertigtes Polymersubstrat 40, das im Wesentlichen deckungsgleich zum ersten Polymersubstrat 20 und der Polymermembran 60 ausgebildet ist, mit den in der zweiten Oberfläche 41 des zweiten Polymersubstrats 40 ausgebildeten Strukturen 44, 46 dem bereits verfügten Zwischenverbund zugewandt, auf diesen Zwischenverbund aufgelegt und mit der zweiten Druckplatte 50 (in Fig. 2B von oben) angepresst.

Das vorgefertigte zweite Polymersubstrat 40 umfasst die zweite Oberfläche 41, in der ein erster Kanal 42 und ein zweiter Kanal 44 ausgebildet sind. Dabei können der erste und zweite Kanal 42, 44 durch einen Verbindungskanal 46 zusätzlich und direkt miteinander verbunden sein, siehe z.B. Fig. 2A. Der erste Kanal 42 ist so ausgebildet, dass, wenn die zweite Oberfläche 41 auf der dazwischen angeordneten Polymermembran 60, die an der ersten Oberfläche 21 anliegt, aufgesetzt ist, der erste Kanal 42 den Bereich, der in der zweiten Oberfläche 41 in Verlängerung des ersten Durchlochs 24 angeordnet ist, mit dem Bereich, der in der zweiten Oberfläche 41 in Verlängerung des ersten Hilfsdurchlochs 25 angeordnet ist, und einem nahe gelegenen ersten Bereich 43, der in der zweiten Oberfläche 41 gegenüber einem entsprechenden Teilbereich der Ausnehmung 22 angeordnet ist, miteinander verbindet. In korrespondierender Weise ist der zweite Kanal 44 so ausgebildet, dass er den Bereich, der in der zweiten Oberfläche 41 in Verlängerung des zweiten Durchlochs 27 angeordnet ist, mit dem Bereich, der in der zweiten Oberfläche 41 in Verlängerung des zweiten Hilfsdurchlochs 28 angeordnet ist, und einem nahe gelegenen zweiten Bereich 45, der in der zweiten Oberfläche 41 gegenüber einem Teilbereich der Ausnehmung 22 angeordnet ist, miteinander verbindet, wie in den Figuren 2A und 2B gezeigt.

Die Grundplatte 30 der Pressvorrichtung in Fig. 2B enthält nun ebenfalls vier Durchlöcher 34, 35, 37, 38, die mit den Durchlöchern 24, 25, 27 und 28 im ersten Polymersubstrat 20 im Wesentlichen deckungsgleich angeordnet sind und diese dadurch fluidisch kontaktieren. Zusätzlich sind die Durchlöcher 34, 35, 37, 38 in der Grundplatte 30 und die entsprechenden Durchlöcher 24, 25, 27, 28 im ersten Polymersubstrat z.B. mit O-Ringen (nicht gezeigt) abgedichtet.

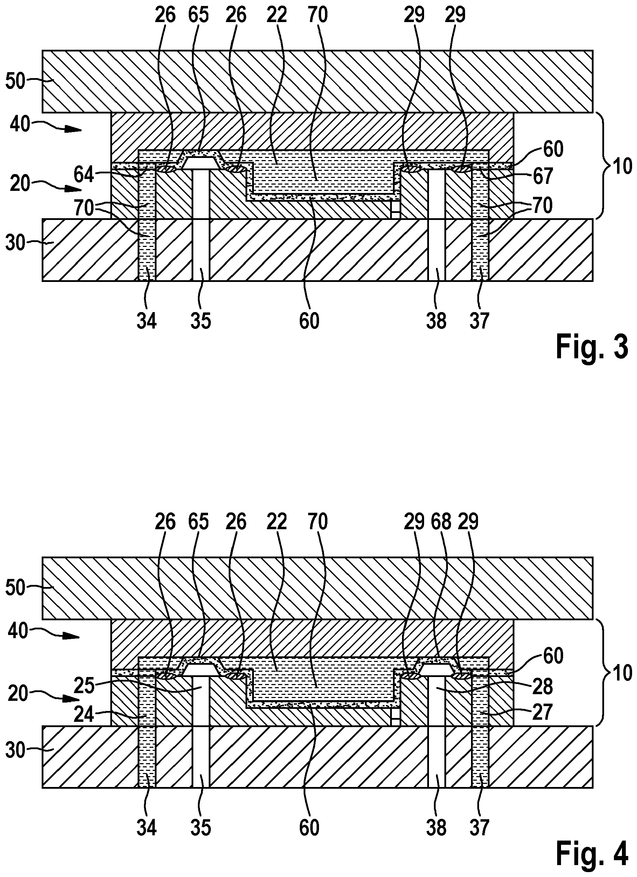

In einem weiteren Prozessschritt (vgl. Fig. 3) werden durch das dritte Durchloch 37 in der Grundplatte 30 und das zweite Durchloch 27 im ersten Polymersubstrat und die zweite Öffnung 67 in der Polymermembran 60 der zweite Kanal 44, die Ausnehmung 22, der Verbindungskanal 46 und der erste Kanal 42 mit einem Fluid zur Vorlagerung befüllt, bis das Fluid durch die erste Öffnung 64 in der Polymermembran 60, das erste Durchloch 24 im ersten Polymersubstrat 20 und das erste Durchloch 34 in der Grundplatte 30 gerade beginnt auszutreten. Daraufhin wird in dem zusammengepressten Polymerstapel 20, 60, 40 durch das zweite Durchloch 35 in der Grundplatte 30 und das erste Hilfsdurchloch 25 in dem ersten Polymersubstrat 20 ein Überdruck beaufschlagt, sodass sich die Polymermembran 60 in einem Bereich in Verlängerung des ersten Hilfsdurchlochs 25 anhebt und an die Wand des ersten Kanals 42 gedrückt wird. Durch die dadurch bewirkte Abdichtung des ersten Kanals 42 und eine gleicheichzeitige weitere Zufuhr von Fluid durch die Durchlöcher 37, 27 dehnt sich die Polymermembran 60 in die Ausnehmung 22 (die Kavität) hinein aus und wird schließlich im Wesentlichen gegen die Innenwand der Ausnehmung 22 angedrückt. Dabei wird die elastische Polymembran 60 vorgespannt. Etwaige sich in der Ausnehmung 22 zwischen der Polymermembran 60 und dem ersten Polymersubstrat 20 befindliche Luft kann durch den Entlüftungskanal 23 entweichen, siehe Fig. 3.

In einem weiteren Prozessschritt (vgl. Fig. 4) wird in dem zusammengepressten Polymerstapel 20, 60, 40 durch das vierte Durchloch 38 in der Grundplatte und das zweite Hilfsdurchloch 28 in dem Polymersubstrat ein Überdruck beaufschlagt, sodass sich die Polymermembran 60 in einem Bereich in Verlängerung des zweiten Hilfsdurchlochs 28 anhebt und an die Wand des zweiten Kanals 44 gedrückt wird. Dadurch wird das Fluid in der Ausnehmung 22 eingeschlossen, siehe Fig. 4.

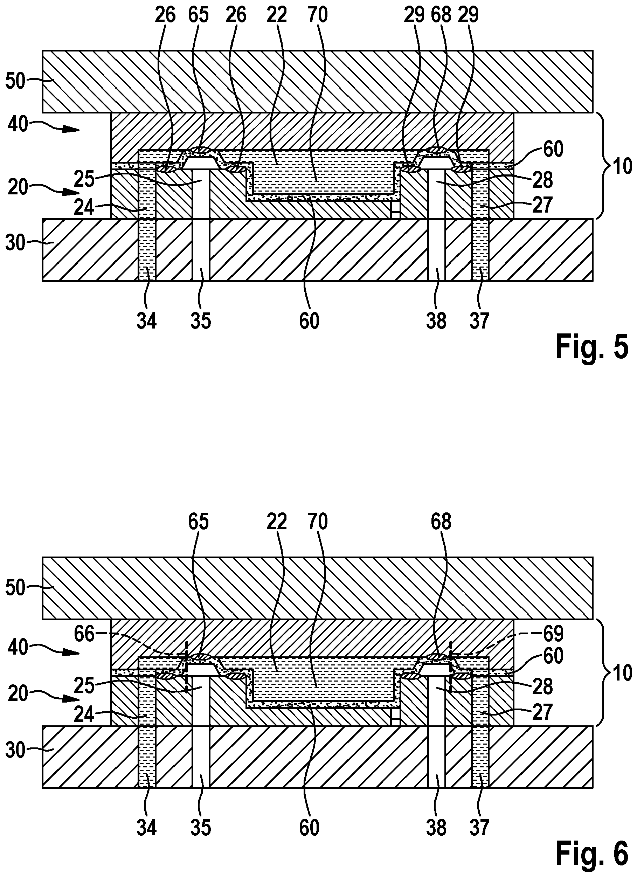

In einem weiteren Prozessschritt (vgl. Fig. 5) wird die Polymermembran 60 in denjenigen Bereichen (bei 65 und 68 in Fig. 5), die in Kontakt mit den Wänden der Kanäle 42 und 44 sind, mit dem zweiten Polymersubstrat 40 verfügt. Dies geschieht insbesondere mittels Laserschweißen. Dabei wird die Polymembran 60 mit einem Laserstrahl (nicht gezeigt) durch die transparente zweite Druckplatte 50 hindurch angestrahlt (und z.B. fokussiert), dadurch aufgeschmolzen und mit dem Polymersubstrat 40 verschweißt, siehe Fig. 5.

In einem weiteren, insbesondere optionalen, Prozessschritt (vgl. Fig. 6) wird die Polymermembran 60 in einem ersten Bereich bzw. einer ersten Durchtrennstelle 66, die sich zwischen der ersten Kontaktstelle 65 und der ersten Öffnung 64 befindet, und in einem zweiten Bereich an einer zweiten Durchtrennstelle 69, die sich zwischen der zweiten Kontaktstelle 68 und der zweiten Öffnung 67 befindet, mit einem Laserstrahl mit höherer Leistung des Lasers durchtrennt, siehe Fig. 6.

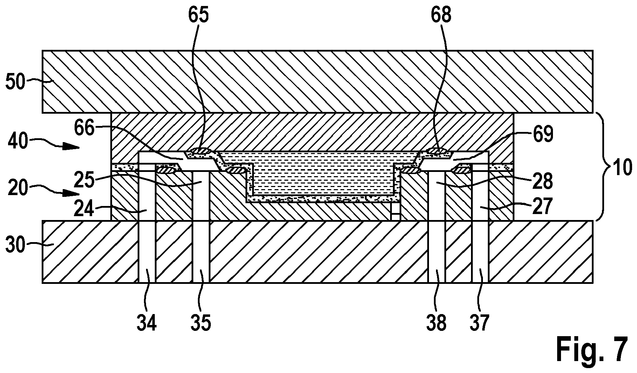

Nach dem Durchtrennen an den Durchtrennstellen 66, 69 kann der Überdruck an dem ersten Hilfsdurchloch 25 bzw. dem zweiten Hilfsdurchloch 28 das außerhalb der Kontaktstellen 65, 68 in dem ersten bzw. zweiten Kanal 42, 44 befindliche Fluid durch das erste Durchloch 24 und das erste Durchloch 34 bzw. durch das zweite Durchloch 27 und das dritte Durchloch 37 verdrängen und dadurch das überschüssige Fluid kontrolliert abführen, siehe Fig. 7.

In einem weiteren Prozessschritt wird der Rest der Oberflächen 21 und 41, d.h. die Bereiche außerhalb der Ausnehmung 22 und außerhalb der bereits verfügten Kontaktstellen 65, 68, mit der Polymermembran 60 gefügt. Insbesondere geschieht auch dies mittels Laserschweißen. Dabei wird der Laserstrahl (nicht gezeigt) wiederum durch die zweite Druckplatte 50 und das zweite Polymersubstrat 40 auf die Polymermembran 60 gerichtet (und z.B. fokussiert), und die restlichen (d.h. zu verfügenden) Bereich der Oberflächen 21 und 41 mit dem (z.B. fokussierten) Laserstrahl abgetastet, dadurch aufgeschmolzen und und mit dem Polymersubstrat 40 verschweißt.

In einer weiteren, nicht gezeigten Ausführungsform sind die Wände des ersten bzw. zweiten Kanals 42 und 44 in den Bereichen (um 65 und um 68 in den Figuren 6 und 7 herum) abgeschrägt. Dadurch wird sichergestellt, dass die beim Anlegen von Überdruck an den Hilfsdurchlöchern 25, 28 in die Kanäle 42, 44 hinein auslenkende Polymermembran 60 im Wesentlichen überall Kontakt zur Kanalwand hat, was die Dichtheit verbessert.

In einer noch weiteren, nicht gezeigten Ausführungsform kann auf die Vertiefung 22 verzichtet werden oder die Vertiefung 22 nur vergleichsweise untief ausgestaltet sein. Diese Ausführungsform ist dann sinnvoll, wenn die vorzulagernde Fluidmenge gering ist und eine Vorlagerung unter Druck nicht benötigt wird.

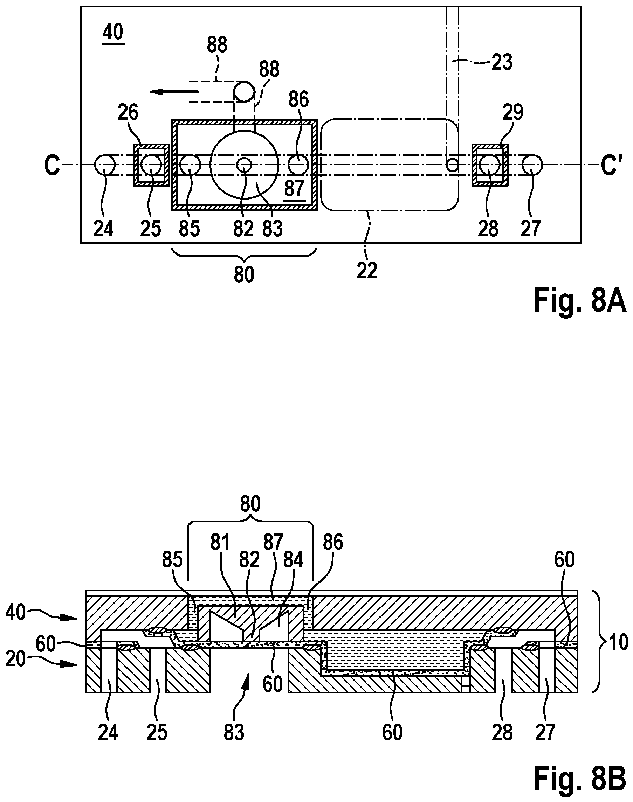

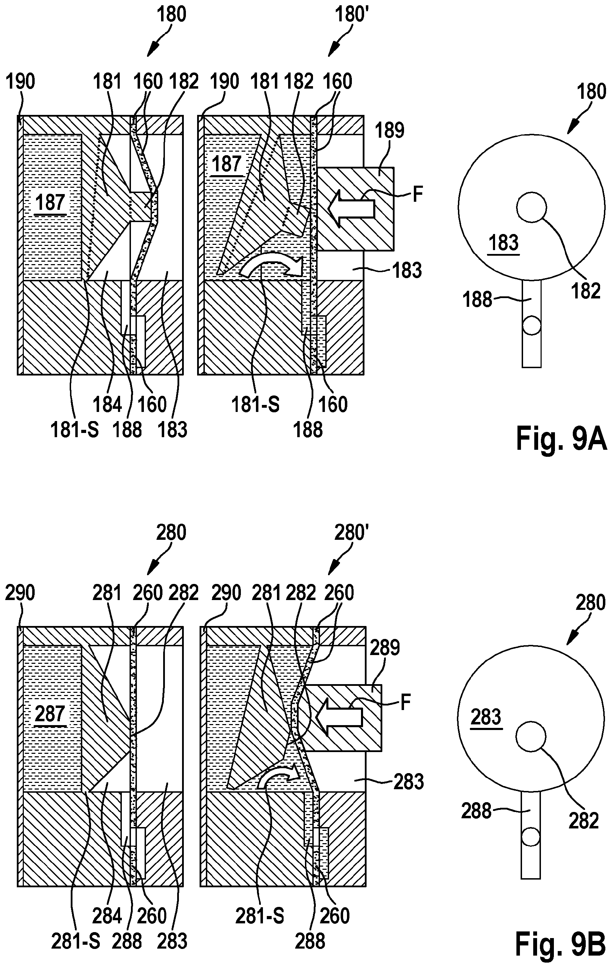

In einer in den Figuren 8A und 8B gezeigten zweiten Ausführungsform der Erfindung umfasst die mikrofluidische Lagerungsvorrichtung 10 ferner mindestens ein Durchbruchventil 80 zum Entleeren des vorgelagerten Fluids 70. Das Durchbruchventil 80 ist im Wesentlichen in einer Öffnung 83 in dem ersten Polymersubstrat 20 ausgebildet umfasst einen Ventilvorraum 87, der in Fluidkommunikation mit der Ausnehmung 22 ist. Zumindest in Teilbereichen kann der Ventilvorraum 87 dem ersten bzw. zweiten Kanal 42, 44 in dem zweiten Polymersubstrat 40 gegenüberliegend und ferner zwischen der Ausnehmung 22 und dem ersten bzw. zweiten Hilfsdurchloch 25, 28 ausgebildet sein, wie in den Figuren 8A und 8B gezeigt. Das Durchbruchsventil 80 umfasst ferner einen Ventildichtabschnitt 81, der beispielsweise konisch ausgebildet ist und ein großflächiges und ein kleinflächiges Ende besitzt, wobei das großflächige Ende den Ventilvorraum 87 begrenzt. Am kleinflächigen Ende ist ein ein Stift 82 ausgebildet, der zur Aktuierung des Berstventils 80 dient, wie weiter unten und bezüglich der Fig. 9A beschrieben ist.

Der erste Kanal 42 aus den Figuren 1 bis 7 ist in der zweiten Ausführungsform der Figuren 8A und 8B modifiziert und um das Berstventil 80 herum ausgebildet. Der modifizierte erste Kanal umfasst einen Kanalabschnitt, der sich gegenüberliegend dem ersten Durchloch 24 und dem ersten Hilfsdurchloch 25 befindet, ein erstes Fülldurchloch 85, den Ventilvorraum 87, ein zweites Fülldurchloch 86 und einen Abschnitt, der bis in bzw. über die Vertiefung 22 führt, wie am besten in Fig. 8B zu sehen ist.

Das Berstventil 80 wird aktiviert, indem ein Druck auf den Stift 82 z.B. in Richtung zum dem großflächigen Ende des Ventildichtabschnitts 81 ausgeübt wird (nicht gezeigt). Dabei reißt das großflächige Ende des Ventildichtabschnittts 81 entlang eines umlaufenden schmalen Stegs von der Innenwand der Öffnung 83 ab und gibt eine dem Ventilvorraum 87 eine Entweichöffnung frei. Das aufgrund der vorgespannten elastischen Polymermembran 60 unter einem Vordruck stehende Fluid strömt, getrieben durch den Vordruck, durch die entstandene Entweichöffnung und wird dadurch freigegeben.

Mögliche Aufbauten, zwei Varianten 180, 280 und die Funktionsweise des in der erfindungsgemäßen Lagerungsvorrichtung 10 der Figuren 8A und 8B eingebauten Berstventils sowie dessen Funktionsweise werden im folgenden noch ausführlicher mit Verweis auf die Figuren 9A und 9B erläutert.

In einer ersten in Fig. 9A gezeigten Ausführungsform ist ein Berstventil 180, 180' in einer Öffnung 183 eines Polymersubstrats angeordnet. Das Berstventil 180 umfasst einen im Wesentlichen konisch ausgebildeten Ventildichtabschnitt 181 und ein am dünneren bzw. hinteren Ende des Ventildichtabschnitts 181 ausgebildeten Stift 182. Das breitere Ende des Ventildichtabschnitts 181 begrenzt einen Ventilvorraum 187, der zumindest teilweise innerhalb der Öffnung 183 angeordnet ist. Am Umfang des breiteren Endes des konischen Ventildichtabschnitts 181 ist der Ventildichtabschnitt 181 über einen umlaufenden schmalen Steg mit dem die Öffnung 183 umgebenden Polymersubstrat verbunden. Der umlaufende Steg reißt bei Ausübung eines Drucks auf den Stift 182 ab und bildet so eine Öffnung bzw. Fluidkommunikation von dem Ventilvorraum 187 in die Kavität 184 und weiter in einen mit der Kavität 184 in Fluidkommunikation stehenden Kanal 188 zum Abführen bzw. Entleeren von Fluid, das sich aus dem bis dahin dichten Ventilvorraum 187 nach dem Abreißen und Freigeben der Öffnung entleeren kann.

Der um das breitere Ende des Ventildichtabschnitts 181 umlaufende Steg ist in der ersten Ausführungsform der Fig. 9A ungleichmäßig breit ausgebildet, und ist an einer vordefinierten Sollbruchstelle 181-S am schmalsten, sodass der Abriss bzw. eine Öffnung immer an dieser vordefinierten Stelle 181-S entsteht und dass im Übrigen gewährleistet ist, dass der Ventildichtabschnitt 181 mit dem Stift 182 mit der Wand der Öffnung 183 verbunden bleibt und nicht in andere Bereiche des mikrofluidischen Kanalsystems vagabundieren kann.

Die Polymermembran 160 erstreckt sich lateral durch die Öffnung 183 und begrenzt die durch das Abreißen des Stegs bzw. durch das Ausbilden der Öffnung freigegebene Kavität 184 und, wie im Ausführungsbeispiel der Fig. 9A, beispielsweise auch den Abflusskanal 188.

Der Druck auf den Stift 182 wird durch einen Stempel 189 beaufschlagt, vgl. die auf den Stempel 189 wirkende, in Fig. 9A gezeigte Kraft F. Dabei wirkt der Stempel 189 durch die Polymermembran 160 hindurch auf den Stift 182.

Mit Ausnahme des ungleichmäßig ausgebildeten umlaufenden Stegs und des radial in die Kavität 184 mündenden Abflusskanals 188 ist das Berstventil 180, 180' in Fig. 9A im Wesentlichen axial symmetrisch ausgebildet, wie in der Aufsicht im rechten Teil der Fig. 9A zu sehen ist. Im linken Teil der Fig. 9A ist das Berstventil 180 in geschlossenem Zustand gezeigt. Dabei kann die Polymermembran 160 über den Stift 182 vorgespannt sein. Im mittleren Bereich der Fig. 9A ist das Berstventil 180' im geöffneten Zustand gezeigt. Dabei hat der Stempel 189 auf den Stift 182 eingewirkt, der Ventildichtabschnitt 181 ist an der Sollbruchstelle 181-S abgerissen und hat die Öffnung vom Ventilvorraum 187 in die Kavität 184 und den Abflusskanal 188 freigegeben.

In einer in Fig. 9B gezeigten zweiten Ausführungsform ist ein Berstventil 280, 280' in einer Öffnung 283 eines Polymersubstrats angeordnet und umfasst einen Ventildichtabschnitt 281, der exzentrisch konisch ausgebildet ist und sich dadurch von dem im Wesentlichen konischen Ventildichtabschnitt 181 der in Fig. 9A gezeigten ersten Ausführungsform unterscheidet. Der Ventildichtabschnitt 281 ist an seinem breiteren (in Fig. 9B linken) Ende über einen umlaufenden Steg mit der Wand der Öffnung 283 verbunden und begrenzt einen Ventilvorraum 287. An seinem schmaleren (in Fig. 9B rechten) Ende kann der Ventildichtabschnitt 281 einen Stift (nicht gezeigt) oder ein Plateau 282 (wie in Fig. 9B gezeigt) aufweisen. Der Stift (nicht gezeigt) bzw. das Plateau 282 sind exzentrisch in der Öffnung 283 angeordnet, wie am besten in der Aufsicht im rechten Teil der Fig. 9B zu sehen ist.

Zum Betätigen des Berstventils 280 wird über einen Stempel 289 ein Druck exzentrisch auf das schmalere Ende, z.B. das Plateau 282, des Ventildichtabschnitts 281 ausgeübt, vgl. die im mittleren Bereich der Fig. 9B angedeutete, durch den Stempel 289 ausgeübte Kraft F. Die exzentrische Anordnung des Übertragungspunktes der Kraft F auf das exzentrische, rückseitige Ende des Ventildichtabschnitts 281 bewirkt, dass der umlaufende Steg vorzugsweise an einer Sollbruchstelle 281-S von der Wand der Öffnung 283 abreißt, die am dichtesten zu dem exzentrischen Kraftübertragungspunkt liegt. Dies kann zusätzlich unterstützt werden durch eine ungleichmäßige Ausbildung des umlaufenden Stegs, der wie in der in Fig. 9A gezeigten Ausführungsform an der vordefinierten Sollbruchstelle 281-S am schmalsten ausgebildet sein kann.

Die Polymermembran 260 begrenzt, ähnlich wie in der in Fig. 9A gezeigten Ausführungsform die beim Abriss des Stegs bzw. beim Freigeben der Öffnung freigegebene Kavität 284 und den Kanal 288 zum Abführen des Fluids.

Die in den mikrofluidischen Systemen erforderlichen Strukturen (d.h. die Elemente 22, 23, 24, 25, 27, 28 bzw. die Elemente 42, 44, 46 (wie z.B. in Fig. 2 gezeigt) bzw. die Elemente 83, 81, 82 (wie in Fig. 8B gezeigt) bzw. die Elemente 85, 86, 87 (wie ebenfalls in Fig. 8B gezeigt) bzw. die Elemente 187, 181, 182 (wie in Fig. 9A gezeigt) bzw. die Elemente 287, 281 (wie in Fig. 9B gezeigt)) können beispielsweise durch Fräsen, Spritzguss, Heißprägen oder Laserstrukturierung erzeugt werden. Durchbrüche bzw. Öffnungen der Polymermembran 60, 160, 260, wie etwa die Öffnungen 64, 67 (wie in Fig. 2B gezeigt), können beispielsweise durch Stanzen oder Laserstrukturierung erzeugt werden.

Die Polymersubstrate, wie etwa das erste und zweite Polymersubstrat 20, 40 oder 180, 280 können aus Thermoplasten hergestellt sein, wie beispielsweise PC, PP, PE, PMMA, COP oder COC.

Die Polymermembran 60, 160, 260 kann aus einem Elastomer, einem thermoplastischen Elastomer, Thermoplasten oder Heißklebefolien hergestellt werden, wobei das gewählte Material die erforderliche Elastizität aufbringt.

Beispielhafte geometrische Abmessungen für die gezeigten Ausführungsformen sind wie folgt. Die laterale Abmessung der Polymersubstrate 20, 40 kann im Bereich von etwa 10 x 10 mm² bis etwa 200 x 200 mm² gewählt werden. Die Dicke des Polymersubstrats kann im Bereich von etwa 0,5 bis 5 mm gewählt werden. Die Dicke der Polymermembran kann im Bereich von etwa 5 bis 300 µm gewählt werden. Das Volumen der Ausnehmung 22 kann im Bereich von etwa 1 mm³ bis 1000 mm³ gewählt werden.

### Bezugszeichenliste:

- 10: mikrofluidische Lagerungsvorrichtung
- 20: erstes Polymersubstrat
- 21: erste Oberfläche
- 22: Ausnehmung
- 22': Freibereich
- 23: Entlüftungskanal
- 24: erstes Durchloch
- 25: erstes Hilfsdurchloch
- 26: erste Kontur
- 27: zweites Durchloch
- 28: zweites Hilfsdurchloch
- 29: zweite Kontur
- 30: erste Druckplatte bzw. Grundplatte
- 32: Durchlöcher
- 34: erstes Durchloch
- 35: zweites Durchloch
- 37: drittes Durchloch
- 38: viertes Durchloch
- 40: zweites Polymersubstrat
- 41: zweite Oberfläche
- 42: erster Kanal
- 43: erster Bereich
- 44: zweiter Kanal
- 45: zweiter Bereich
- 46: Verbindungskanal
- 50: zweite Druckplatte
- 60: Polymermembran
- 64: erste Öffnung
- 65: erste Kontaktstelle
- 66: erste Durchtrennstelle
- 67: zweite Öffnung
- 68: zweite Kontaktstelle
- 69: zweite Durchtrennstelle
- 70: Fluid
- 80: Durchbruchventil
- 81: Ventildichtabschnitt
- 82: Stift
- 83: Öffnung
- 84: Kavität
- 85: erstes Fülldurchloch
- 86: zweites Fülldurchloch
- 87: Ventilvorraum
- 88: Kanal
- 90: Abdeckschicht
- 160: Polymermembran
- 180, 280: Durchbruchventil (geschlossen)
- 180', 280': Durchbruchventil (offen)
- 181, 281: Ventildichtabschnitt
- 181-S, 282-S: Sollbruchstelle
- 182: Stift
- 282: Plateau
- 183,283: Öffnung
- 184, 284: Kavität
- 187,287: Ventilvorraum
- 188,288: Kanal
- 189, 289: Stempel
- F: Kraft
- 190, 290: Abdeckschicht

## Patentansprüche

1. Mikrofluidische Lagerungsvorrichtung (10) zum Vorlagern eines Fluids (70) mit:
einem ersten Polymersubstrat (20) mit einer ersten Oberfläche (21), in der eine sich lateral erstreckende Ausnehmung (22) ausgebildet ist, wobei das erste Polymersubstrat (20) folgendes umfasst:
- ein erstes Durchloch (24),
- ein erstes Hilfsdurchloch (25), das zwischen dem ersten Durchloch (24) und der Ausnehmung (22) ausgebildet ist,
- ein zweites Durchloch (27), das bezüglich der Ausnehmung (22) dem ersten Durchloch (24) gegenüberliegend angeordnet ist, und
- ein zweites Hilfsdurchloch (28), das zwischen dem zweiten Durchloch (27) und der Ausnehmung (22) ausgebildet ist,
einem zweiten Polymersubstrat (40) mit einer zweiten Oberfläche (41), die im Wesentlichen formschlüssig passend an die erste Oberfläche (21) ausgebildet ist zumindest in Teilbereichen außerhalb der Ausnehmung (21), wobei in der zweiten Oberfläche (41) des zweiten Polymersubstrats (40) ein erster Kanal (42) und ein zweiter Kanal (44) ausgebildet ist, und
einer elastischen Polymermembran (60), die zwischen dem ersten und zweiten Polymersubstrat (20, 40) angeordnet ist, die in Bereichen außerhalb der Ausnehmung (22) mit der ersten und mit der zweiten Oberfläche (21, 41) in Kontakt ist und die im Bereich der Ausnehmung (22) diese (22) im Wesentlichen auskleiden kann, so dass der Volumenbereich innerhalb der Ausnehmung (22) zwischen der Polymermembran (60) und dem zweiten Polymersubstrat (40) mit dem Fluid (70) befüllbar ist,
wobei, die zweite Oberfläche (41) des zweiten Polymersubstrats (40) mit der dazwischen angeordneten Polymermembran (60) derart an die erste Oberfläche (21) des ersten Polymersubstrats (20) angelegt ist, dass der erste Kanal (42) den Bereich, der in der zweiten Oberfläche (41) in Verlängerung des ersten Durchlochs (24) angeordnet ist, mit dem Bereich, der in der zweiten Oberfläche (41) in Verlängerung des ersten Hilfsdurchlochs (25) angeordnet ist, und einem nahe gelegenen ersten Bereich (43), der in der zweiten Oberfläche (41) gegenüber einem Teilbereich der Ausnehmung (22) angeordnet ist, miteinander verbindet, und der zweite Kanal (44) den Bereich, der in der zweiten Oberfläche (41) in Verlängerung des zweiten Durchlochs (27) angeordnet ist, mit dem Bereich, der in der zweiten Oberfläche (41) in Verlängerung des zweiten Hilfsdurchlochs (28) angeordnet ist, und einem nahe gelegenen zweiten Bereich (45), der in der zweiten Oberfläche (41) gegenüber einem Teilbereich der Ausnehmung (22) angeordnet ist, miteinander verbindet,
wobei das erste Polymersubstrat (20), die Polymermembran (60) und das zweite Polymersubstrat (40) zumindest in Teilbereichen außerhalb der Ausnehmung (22), in denen die Polymermembran (60) mit der ersten und der zweiten Oberfläche (21, 41) in Kontakt ist, miteinander verfügbar sind, und
wobei die Polymermembran (60) in den Bereichen des ersten und des zweiten Hilfsdurchlochs (25, 28), welche in Kontakt mit der Wand des ersten bzw. des zweiten Kanals (42, 44) bringbar sind, mit der Wand des ersten bzw. des zweiten Kanals (42, 44) verfügbar ist.

2. Mikrofluidische Lagerungsvorrichtung (10) nach Anspruch 1, **dadurch gekennzeichnet, dass** in dem ersten Polymersubstrat (20) ein Entlüftungskanal (23) ausgebildet ist, der eine Fluidkommunikation zwischen der Ausnehmung (22) und einem Raum außerhalb der Lagerungsvorrichtung (10) bereitstellt.

3. Mikrofluidische Lagerungsvorrichtung (10) nach Anspruch 1 oder 2, **dadurch gekennzeichnet, dass** der erste Kanal (42) und der zweite Kanal (44) in dem Bereich, der sich auf der zweiten Oberfläche (41) gegenüber der Ausnehmung (22) befindet, miteinander verbunden sind.

4. Mikrofluidische Lagerungsvorrichtung (10) nach einem der vorhergehenden Ansprüche, **dadurch gekennzeichnet, dass** die Polymermembran (60) zumindest in Bereichen außerhalb der Ausnehmung (22) in dem Bereich, der in der zweiten Oberfläche (41) in Verlängerung des ersten Hilfsdurchlochs (25) angeordnet ist, mit der Wand des ersten Kanals (42) und in dem Bereich, der in der zweiten Oberfläche (41) in Verlängerung des zweiten Hilfsdurchlochs (28) angeordnet ist, und mit der Wand des zweiten Kanals (44) gefügt ist.

5. Mikrofluidische Lagerungsvorrichtung (10) nach einem der vorhergehenden Ansprüche, **dadurch gekennzeichnet, dass** das Fluid (70) zumindest in dem Volumenbereich in der Ausnehmung (22) zwischen der Polymermembran (60) und der zweiten Oberfläche (41) eingefüllt ist.

6. Mikrofluidische Lagerungsvorrichtung (10) nach einem der vorhergehenden Ansprüche, **dadurch gekennzeichnet, dass** wenigstens das erste Durchloch (24), das erste Hilfsdurchloch (25), das zweite Durchloch (27) oder das zweite Hilfsdurchloch (28) mit einem Polymerstempel verschlossen ist.

7. Mikrofluidische Lagerungsvorrichtung (10) nach einem der vorhergehenden Ansprüche, **dadurch gekennzeichnet, dass** die Lagerungsvorrichtung (10) mindestens ein Durchbruchventil (80) mit einem Ventilvorraum (87) umfasst, wobei das Durchbruchventil (80) in dem ersten Polymersubstrat (20) ausgebildet und der Ventilvorraum (87) in Fluidkommunikation mit der Ausnehmung (22) ist.

8. Mikrofluidische Lagerungsvorrichtung (10) nach einem der vorhergehenden Ansprüche, **dadurch gekennzeichnet, dass** die Wände des ersten bzw. des zweiten Kanals (42, 44) in den Bereichen, in denen die Polymermembran (60) gebogen ist, abgeschrägt ausgebildet sind.

9. Verwendung einer mikrofluidischen Lagerungsvorrichtung (10) nach einem der vorhergehenden Ansprüche in einem Lab-on-a-Chip (LOC).

10. Verfahren zur Herstellung einer mikrofluidischen Lagerungsvorrichtung (10) zum Vorlagern eines Fluids (70), mit den folgenden Schritten:
(a) Herstellen eines ersten Polymersubstrats (20) mit einer ersten Oberfläche (21), in der eine sich lateral erstreckende Ausnehmung (22) ausgebildet sein kann ist, wobei das erste Polymersubstrat (20) ferner ein erstes Durchloch (24), ein erstes Hilfsdurchloch (25), das zwischen dem ersten Durchloch (24) und der Ausnehmung (22) ausgebildet ist, ein zweites Durchloch (27), das bezüglich der Ausnehmung (22) dem ersten Durchloch (24) gegenüberliegend angeordnet ist und ein zweites Hilfsdurchloch (28), das zwischen dem zweiten Durchloch (27) und der Ausnehmung (22) ausgebildet ist, aufweist,
(b) Herstellen eines zweiten Polymersubstrats (40) mit einer zweiten Oberfläche (41), die in Bereichen außerhalb der Ausnehmung (22) im Wesentlichen formschlüssig passend zu der ersten Oberfläche (21) ausgebildet ist und in der ein erster Kanal (42) und ein zweiter Kanal (44) ausgebildet ist,
wobei, wenn die erste Oberfläche (21) des ersten Polymersubstrats (20) an die zweite Oberfläche (41) des zweiten Polymersubstrats (40) gelegt ist, der erste Kanal (42) den Bereich, der in der zweiten Oberfläche (41) in Verlängerung des ersten Durchlochs (24) angeordnet ist, mit dem Bereich, der in der zweiten Oberfläche (41) in Verlängerung des ersten Hilfsdurchlochs (25) angeordnet ist, und einem nahe gelegenen ersten Bereich (43), der in der zweiten Oberfläche (41) gegenüber der Ausnehmung (22) angeordnet ist, miteinander verbindet, und der zweite Kanal (44) den Bereich, der in der zweiten Oberfläche (41) in Verlängerung des zweiten Durchlochs (27) angeordnet ist, mit dem Bereich, der in der zweiten Oberfläche (41) in Verlängerung des zweiten Hilfsdurchlochs (28) angeordnet ist, und einem nahe gelegenen zweiten Bereich (45), der in der zweiten Oberfläche (41) gegenüber der Ausnehmung (22) angeordnet ist, miteinander verbindet;
(c) Ausbilden einer Stapelanordnung umfassend das erste Polymersubstrat (20), das zweite Polymersubstrat (40) und eine Polymermembran (60), die zwischen dem ersten Polymersubstrat (20) und dem zweiten Polymersubstrat (40) angeordnet und in Bereichen außerhalb der Ausnehmung (22) mit der ersten und mit der zweiten Oberfläche (21, 41) in Kontakt gebracht wird, wobei während dieses Schritts das erste und zweite Polymersubstrat (20, 40) in Richtung aufeinander zu aneinandergepresst werden;
(d) Einfüllen des Fluids (70) in das erste Durchloch (24) bis das Fluid (70) durch das zweite Durchloch (27) austritt;
(e) Beaufschlagen eines Überdrucks an das zweite Hilfsdurchloch (28), so dass sich die Polymermembran (60) im Bereich des zweiten Hilfsdurchlochs (28) von dem ersten Polymersubstrat (20) abhebt und im Wesentlichen in diesem Bereich an der Wand des zweiten Kanals (44) angedrückt wird;
(f) weiterhin Einfüllen des Fluids (70) in das erste Durchloch (24) bis sich die Polymermembran (60) in die Ausnehmung (22) hinein gedrückt hat und die Ausnehmung (22) im Wesentlichen auskleidet, und der Volumenbereich zwischen der Polymermembran (60) und dem zweiten Polymersubstrat (40) im Bereich der Ausnehmung (22) vollständig mit Fluid (70) gefüllt ist;
(g) Beaufschlagen eines Überdrucks an das erste Hilfsdurchloch (25), so dass sich die Polymermembran (60) im Bereich des ersten Hilfsdurchlochs (25) von dem ersten Polymersubstrat (20) abhebt und im Wesentlichen in diesem Bereich an der Wand des ersten Kanals (42) angedrückt wird;
(h) Fügen der Polymermembran (60) in den Bereichen des ersten und des zweiten Hilfsdurchlochs (25, 28), die in Kontakt mit der Wand des ersten bzw. des zweiten Kanals (42, 44) sind; und
(i) Fügen der übrigen Flächenbereiche der Oberflächen (21, 41) des ersten und zweiten Polymersubstrats (20, 40) mit der Polymermembran (60) zumindest in Teilbereichen außerhalb der Ausnehmung (22).

11. Verfahren nach Anspruch 10, **dadurch gekennzeichnet, dass** im Schritt (a) die Strukturen (22, 24, 25, 26, 27, 28) in der ersten Oberfläche (21) des ersten Polymersubstrats (20) und/oder im Schritt (b) die Strukturen (42, 43, 44, 45, 46) in der zweiten Oberfläche (41) des zweiten Polymersubstrats (40) durch Fräsen, Spritzguss, Heißprägen oder Laserstrukturierung hergestellt werden.

12. Verfahren nach Anspruch 10 oder 11, **dadurch gekennzeichnet, dass** die Durchbrüche (64, 67) in der Polymermembran (60) in den Bereichen des ersten Durchlochs (24) und/oder des zweiten Durchlochs (27) durch Stanzen oder Laserstrukturierung hergestellt werden.

## Claims

1. Microfluidic storage device (10) for pre-storing a fluid (70), comprising:
a first polymer substrate (20), having a first surface (21) in which a laterally extending recess (22) is formed, wherein the first polymer substrate (20) comprises the following:
- a first through-hole (24),
- a first auxiliary through-hole (25), which is formed between the first through-hole (24) and the recess (22),
- a second through-hole (27), which is arranged opposite the first through-hole (24) in relation to the recess (22), and
- a second auxiliary through-hole (28), which is formed between the second through-hole (27) and the recess (22),
a second polymer substrate (40), having a second surface (41) which is essentially formed so as to match the first surface (21) with a form fit at least in subregions outside the recess (21), wherein a first channel (42) and a second channel (44) are formed in the second surface (41) of the second polymer substrate (40), and
an elastic polymer membrane (60) which is arranged between the first and second polymer substrates (20, 40), is in contact with the first and second surfaces (21, 41) in regions outside the recess (22) and, in the region of the recess (22), can essentially line the latter (22) so that the volume region inside the recess (22), between the polymer membrane (60) and the second polymer substrate (40), can be filled with the fluid (70),
wherein, the second surface (41) of the second polymer substrate (40) is applied onto the first surface (21) of the first polymer substrate (20) with the polymer membrane (60) arranged between them, such that the first channel (42) connects together the region which is arranged in the second surface (41) in extension of the first through-hole (24), the region which is arranged in the second surface (41) in extension of the first auxiliary through-hole (25), and a closely lying first region (43) which is arranged in the second surface (41), facing a subregion of the recess (22), and the second channel (44) connects together the region which is arranged in the second surface (41) in extension of the second through-hole (27), the region which is arranged in the second surface (41) in extension of the second auxiliary through-hole (28), and a closely lying second region (45) which is arranged in the second surface (41), facing a subregion of the recess (22),
wherein the first polymer substrate (20), the polymer membrane (60) and the second polymer substrate (40) can be joined to one another at least in subregions, outside the recess (22), in which the polymer membrane (60) is in contact with the first and second surfaces (21, 41), and
wherein the polymer membrane (60) can be joined to the wall of the first or second channel (42, 44) in the regions of the first or second auxiliary through-hole (25, 28) which can be brought into contact with the wall of the first or second channel (42, 44).

2. Microfluidic storage device (10) according to Claim 1, **characterized in that** a venting channel (23), which provides fluid communication between the recess (22) and a space outside the storage device (10), is formed in the first polymer substrate (20).

3. Microfluidic storage device (10) according to Claim 1 or 2, **characterized in that** the first channel (42) and the second channel (44) are connected together in the region which lies on the second surface (41), facing the recess (22).

4. Microfluidic storage device (10) according to one of the preceding claims, **characterized in that**, at least in regions outside the recess (22), the polymer membrane (60) is joined to the wall of the first channel (42) in the region which is arranged in the second surface (41) in extension of the first auxiliary through-hole (25), and to the wall of the second channel (44) and in the region which is arranged in the second surface (41) in extension of the second auxiliary through-hole (28).

5. Microfluidic storage device (10) according to one of the preceding claims, **characterized in that** at least the volume region in the recess (22), between the polymer membrane (60) and the second surface (41), is filled with the fluid (70).

6. Microfluidic storage device (10) according to one of the preceding claims, **characterized in that** at least the first through-hole (24), the first auxiliary through-hole (25), the second through-hole (27) or the second auxiliary through-hole (28) is closed by a polymer stamp.

7. Microfluidic storage device (10) according to one of the preceding claims, **characterized in that** the storage device (10) comprises at least one breakthrough valve (80) having a valve antechamber (87), the breakthrough valve (80) being formed in the first polymer substrate (20) and the valve antechamber (87) being in fluid communication with the recess (22).

8. Microfluidic storage device (10) according to one of the preceding claims, **characterized in that** the walls of the first and second channels (42, 44) are respectively formed with a chamfer in the regions in which the polymer membrane (60) is curved.

9. Use of a microfluidic storage device (10) according to one of the preceding claims in a lab-on-a-chip (LOC).

10. Method for producing a microfluidic storage device (10) for pre-storing a fluid (70), comprising the following steps:
(a) producing a first polymer substrate (20), having a first surface (21) in which a laterally extending recess (22) can be formed, the first polymer substrate (20) furthermore having a first through-hole (24), a first auxiliary through-hole (25), which is formed between the first through-hole (24) and the recess (22), a second through-hole (27), which is arranged opposite the first through-hole (24) in relation to the recess (22), and a second auxiliary through-hole (28), which is formed between the second through-hole (27) and the recess (22);
(b) producing a second polymer substrate (40), having a second surface (41) which is essentially formed so as to match the first surface (21) with a form fit in regions outside the recess (22) and in which a first channel (42) and a second channel (44) are formed,
wherein, when the first surface (21) of the first polymer substrate (20) is applied onto the second surface (41) of the second polymer substrate (40), the first channel (42) connects together the region which is arranged in the second surface (41) in extension of the first through-hole (24), the region which is arranged in the second surface (41) in extension of the first auxiliary through-hole (25), and a closely lying first region (43) which is arranged in the second surface (41), facing the recess (22), and the second channel (44) connects together the region which is arranged in the second surface (41) in extension of the second through-hole (27), the region which is arranged in the second surface (41) in extension of the second auxiliary through-hole (28), and a closely lying second region (45) which is arranged in the second surface (41), facing the recess (22);
(c) forming a stack arrangement comprising the first polymer substrate (20), the second polymer substrate (40) and a polymer membrane (60), which is arranged between the first polymer substrate (20) and the second polymer substrate (40) and is brought into contact with the first and with the second surface (21, 41) in the regions outside the recess (22), wherein, during this step, the first and second polymer substrate (20, 40) are pressed against one another in a direction toward one another;
(d) filling the first through-hole (24) with the fluid (70) until the fluid (70) emerges through the second through-hole (27);
(e) applying a positive pressure to the second auxiliary through-hole (28), so that the polymer membrane (60) is raised from the first polymer substrate (20) in the region of the second auxiliary through-hole (28) and is essentially pressed onto the wall of the second channel (44) in this region;
(f) continuing to fill the first through-hole (24) with the fluid (70) until the polymer membrane (60) has been pressed into the recess (22) and essentially lines the recess (22), and the volume region between the polymer membrane (60) and the second polymer substrate (40) is filled fully with fluid (70) in the region of the recess (22);
(g) applying a positive pressure to the first auxiliary through-hole (25), so that the polymer membrane (60) is raised from the first polymer substrate (20) in the region of the first auxiliary through-hole (25) and is essentially pressed onto the wall of the first channel (42) in this region;
(h) joining the polymer membrane (60) in the regions of the first and second auxiliary through-holes (25, 28) which are respectively in contact with the walls of the first and second channels (42, 44); and
(i) joining the remaining planar regions of the surfaces (21, 22) of the first and second polymer substrates (20, 40) to the polymer membrane (60) at least in subregions outside the recess (22).

11. Method according to Claim 10, **characterized in that** the structures (22, 24, 25, 26, 27, 28) in the first surface (21) of the first polymer substrate (20) are produced by milling, injection molding, hot pressing or laser structuring in step (a), and/or the structures (42, 43, 44, 45, 46) in the second surface (41) of the second polymer substrate (40) are produced by milling, injection molding, hot pressing or laser structuring in step (b).

12. Method according to Claim 10 or 11, **characterized in that** the breakthroughs (64, 67) in the polymer membrane (60) in the regions of the first through-hole (24) and/or of the second through-hole (27) are produced by stamping or laser structuring.

## Revendications

1. Dispositif micro-fluidique de stockage (10), destiné à pré-stocker un fluide (70), comportant :
un premier substrat polymère (20), pourvu d'une première surface .(21), dans laquelle est conçu un évidement (22) qui s'étend dans la direction latérale, le premier substrat polymère (20) comportant ce qui suit :
- un premier trou traversant (24),
- un premier trou traversant auxiliaire (25), qui est conçu entre le premier trou traversant (24) et l'évidement (22),
- un deuxième trou traversant (27), qui par rapport à l'évidement (22) est placé au vis-à-vis du premier trou traversant (24) et
- un deuxième trou traversant auxiliaire (28), qui est conçu entre le deuxième trou traversant (27) et l'évidement (22),
un deuxième substrat polymère (40) pourvu d'une deuxième surface (41), qui est conçue sensiblement en adaptation par complémentarité de forme à la première surface (21), au moins dans des zones partielles extérieures à l'évidement (21), dans la deuxième surface (41) du deuxième substrat polymère (40) étant conçus un premier canal (42) et un deuxième canal (44) et
une membrane polymère élastique (60), qui est placée entre le premier et le deuxième substrats polymères (20, 40), qui dans des zones extérieures à l'évidement (22) est en contact avec la première et la deuxième surfaces (21, 41) et dans la région de l'évidement (22) est susceptible d'habiller sensiblement celui-ci (22), de sorte que le volume à l'intérieur de l'évidement (22), entre la membrane polymère (60) et le deuxième substrat polymère (40) puisse être rempli avec le fluide (70),
la deuxième surface (41) du deuxième substrat polymère (40) avec la membrane polymère (60) intercalée étant appliquée sur la première surface (21) du premier substrat polymère (20) de telle sorte que le premier canal (42) relie les unes aux autres la zone, qui dans la deuxième surface (41) est placée dans le prolongement du premier trou traversant (24) avec la zone, qui dans la deuxième surface (41) est placée dans le prolongement du premier trou traversant auxiliaire (25) et une première zone (43) proche, qui dans la deuxième surface (41) est placée en vis-à-vis d'une zone partielle de l'évidement (22), et que le deuxième canal (44) relie les unes aux autres la zone, qui dans la deuxième surface (41) est placée dans le prolongement du deuxième trou traversant (27) avec la zone, qui dans la deuxième surface (41) est placée dans le prolongement du deuxième trou traversant auxiliaires (28) et une deuxième zone (45) proche, qui dans la deuxième surface (41) est placée au vis-à-vis d'une zone partielle de l'évidement (22),
le premier substrat polymère (20), la membrane polymère (60) et la deuxième substrat polymère (40) étant co-disponibles au moins dans des zones partielles extérieures à l'évidement (22), dans lesquelles la membrane polymère (60) est en contact avec la première et la deuxième surfaces (21, 41) et
la membrane polymère (60) étant disponible avec la paroi du premier ou du deuxième canal (42, 44) dans les zones du premier et du deuxième trous traversants auxiliaires (25, 28), lesquelles peuvent être amenées en contact avec la paroi de premier ou du deuxième canal (42, 44).

2. Dispositif micro-fluidique de stockage (10) selon la revendication 1, **caractérisé en ce que** dans le premier substrat polymère (20) est conçu un canal de purge (23) qui met à disposition une communication fluidique entre l'évidement (22) et un espace extérieur au dispositif de stockage (10).

3. Dispositif micro-fluidique de stockage (10) selon la revendication 1 ou 2, **caractérisé en ce que** le premier canal (42) et le deuxième canal (44) sont reliés l'un à l'autre dans la zone, qui sur la deuxième surface (41) se trouve au vis-à-vis de l'évidement (22).

4. Dispositif micro-fluidique de stockage (10) selon l'une quelconque des revendications précédentes, **caractérisé en ce qu'**au moins dans des zones extérieures à l'évidement (22) dans la zone, qui dans la deuxième surface (41) est placée dans le prolongement du premier trou traversant auxiliaire (25), la membrane polymère (60) est assemblée avec la paroi du premier canal (42) et dans la zone, qui dans la deuxième surface (41) est placée dans le prolongement du deuxième trou traversant auxiliaire (28) et est assemblée avec la paroi du deuxième canal (44).

5. Dispositif micro-fluidique de stockage (10) selon l'une quelconque des revendications précédentes, **caractérisé en ce que** le fluide (70) est versé au moins dans le volume de l'évidement (22) entre la membrane polymère (60) et la deuxième surface (41).

6. Dispositif micro-fluidique de stockage (10) selon l'une quelconque des revendications précédentes, **caractérisé en ce qu'**au moins le premier trou traversant (24), le premier trou traversant auxiliaire (25), le deuxième trou traversant (27) ou le deuxième trou traversant auxiliaire (28) sont fermés par un poinçon polymère.

7. Dispositif micro-fluidique de stockage (10) selon l'une quelconque des revendications précédentes, **caractérisé en ce que** le dispositif de stockage (10) comprend au moins une soupape de rupture (80) avec un dégagement de soupape (87), la soupape de rupture (80) étant conçue dans le premier substrat polymère (20) et le dégagement de soupape (87) étant en communication fluidique avec l'évidement (22).

8. Dispositif micro-fluidique de stockage (10) selon l'une quelconque des revendications précédentes, **caractérisé en ce que** les parois du premier ou du deuxième canal (42, 44) sont conçues avec un chanfrein dans les zones dans lesquelles la membrane polymère (60) est recourbée.

9. Utilisation d'un dispositif micro-fluidique de stockage (10) selon l'une quelconque des revendications précédentes dans un micro-laboratoire sur puce (LOC).

10. Procédé, destiné à produire un dispositif micro-fluidique de stockage (10) destiné à pré-stocker un fluide (70), comportant les étapes consistant à :
(a) produire un premier substrat polymère (20) pourvu d'une première surface (21), dans laquelle peut être conçu un évidement (22) s'étendant en direction latérale, le premier substrat polymère (20) comportant en outre un premier trou traversant (24), un premier trou traversant auxiliaire (25), qui est conçu entre le premier trou traversant (24) et l'évidement (22), un deuxième trou traversant (27), qui par rapport à l'évidement (22) est placé au vis-à-vis du premier trou traversant (24) et un deuxième trou traversant auxiliaire (28), qui est conçu entre le deuxième trou traversant (27) et l'évidement (22),
(b) produire un deuxième substrat polymère (40) pourvu d'une deuxième surface (41), qui dans des zones extérieures à l'évidement (22) est conçue en adaptation sensible par complémentarité de forme avec la première surface (21) et dans laquelle sont conçus un premier canal (42) et un deuxième canal (44),
lorsque la première surface (21) du premier substrat polymère (20) est posée sur la deuxième surface (41) du deuxième substrat polymère (40), le premier canal (42) reliant entre elles la zone, qui dans la deuxième surface (41) est placée dans le prolongement du trou traversant (24) avec la zone, qui dans la deuxième surface (41) est placée dans le prolongement du premier trou traversant auxiliaire (25) et une première zone (43) proche, qui dans la deuxième surface (41) est placée au vis-à-vis de l'évidement (22), et le deuxième canal (44) reliant entre elles la zone, qui dans la deuxième surface (41) est placée dans le prolongement du deuxième trou traversant (27) avec la zone, qui dans la deuxième surface (41) est placée dans le prolongement du deuxième trou traversant auxiliaire (28) et une deuxième zone (45) proche, qui dans la deuxième surface (41) est placée au vis-à-vis de l'évidement (22);
(c) créer une configuration en empilement comprenant le premier substrat polymère (20), le deuxième substrat polymère (40) et une membrane polymère (60), qui est placée entre le premier substrat polymère (20) et le deuxième substrat polymère (40) et dans des zones extérieures à l'évidement (22) est amenée en contact avec la première et la deuxième surfaces (21, 41), pendant cette étape, le premier et le deuxième substrats polymères (20, 40) étant pressés l'un contre l'autre, dans la direction l'un vers l'autre ;
(d) verser le fluide (70) dans le premier trou traversant (24) jusqu'à ce que le fluide (70) sorte du deuxième trou traversant (27) ;
(e) exposer le deuxième trou traversant auxiliaire (28) à une surpression, de sorte que dans la zone du deuxième trou traversant auxiliaire (28), la membrane polymère (60) se soulève du premier substrat polymère (20) et soit pressée essentiellement dans cette zone sur la paroi du deuxième canal (44) ;
(f) continuer à verser du fluide (70) dans le premier trou traversant (24) jusqu'à ce que la membrane polymère (60) se soit poussée dans l'évidement (22) et habille sensiblement l'évidement (22) et le volume entre la membrane polymère (60) et le deuxième substrat polymère (40) soit totalement rempli de fluide (70), dans la zone de l'évidement (22) ;
(g) exposer le premier trou traversant auxiliaire (25) à une surpression, de sorte que dans la zone du premier trou traversant auxiliaire (25), la membrane polymère (60) se soulève du premier substrat polymère (20) et essentiellement dans cette zone soit pressée sur la paroi du premier canal (42) ;
(h) assembler la membrane polymère (60) dans les zones du premier et du deuxième trous traversants auxiliaires (25, 28), qui sont en contact avec la paroi du premier ou du deuxième canal (42, 44) ; et
(i) assembler les autres zones superficielles des der surfaces (21, 41) du premier et du deuxième substrats polymères (20, 40) avec la membrane polymère (60), au moins dans des zones partielles extérieures à l'évidement (22).

11. Procédé selon la revendication 10, **caractérisé en ce que** dans l'étape (a), on produit les structures (22, 24, 25, 26, 27, 28) dans la première surface (21) du premier substrat polymère (20) et/ou dans l'étape (b), on produit les structures (42, 43, 44, 45, 46) dans la deuxième surface (41) du deuxième substrat polymère (40) par fraisage, moulage par injection, estampage à chaud ou structuration au laser.

12. Procédé selon la revendication 10 ou 11, **caractérisé en ce que** les ajours (64, 67) dans la membrane polymère (60) sont ménagés dans la zone du premier trou traversant (24) et/ou du deuxième trou traversant (27) par découpage ou structuration au laser.
